## Europäisches Patentamt

## European Patent Office

## Office européen des brevets

(19)

(11) Numéro de publication: **0 005 442**
**B1**

(12) **FASCICULE DE BREVET EUROPEEN**

(45) Date de publication du fascicule de brevet:
**13.05.81**

(51) Int. Cl.³: **C 23 C 11/08**, C 30 B 25/02

(21) Numéro de dépôt: **79101058.0**

(22) Date de dépôt: **06.04.79**

(54) **Procédé et dispositif de formation de nitrure d'aluminium convenant à des applications électroniques.**

(30) Priorité: **15.05.78 US 905625**

(43) Date de publication de la demande:
**28.11.79 Bulletin 79/24**

(45) Mention de la délivrance du brevet:
**13.05.81 Bulletin 81/19**

(84) Etats contractants désignés:
**DE FR GB**

(56) Documents cités:
**FR-A-2 096 394**

**IBM TECHNICAL DISCLOSURE BULLETIN,
vol. 17, n° 9, février 1975
J. J. CUOMO et R. F. RUTZ:
«Growing large area silicon carbide and aluminium nitride crystals»,
pages 2819 et 2820**

(73) Titulaire: **International Business Machines Corporation,
Armonk, N.Y. 10504 (US)**

(72) Inventeur: **Rutz, Richard, Frederick, Route No.1 Box
No. 253, Cold Spring Putnam New York 10516 (US)**

(74) Mandataire: **Klein, Daniel, COMPAGNIE IBM FRANCE
Département de Propriété Industrielle, F-06610 La Gaude
(FR)**

## Procédé et dispositif de formation de nitrure d'aluminium convenant à des applications électroniques

Domaine Technique

La présente invention concerne un procédé et un dispositif de formation de nitrure d'aluminium notamment sous forme de couches convenant à des applications électroniques.

Le nitrure d'aluminium est un matériau fortement réfractaire qui, ainsi qu'on l'a récemment découvert, présente une électroluminescence et une photoluminescence correspondant à des longueurs d'onde extrêmement courtes. Cependant, pour présenter une bonne électroluminescence et d'autres propriétés souhaitables, le nitrure d'aluminium doit être formé et fabriqué à des températures si élevées que la plupart des matériaux utilisés à cette fin réagissent entre eux et introduisent des contaminations qui nuisent à son comportement électronique.

Etat de la Technique Antérieure

Un article intitulé «Ultraviolet Electroluminescence in Aluminium Nitride», paru dans la publication «Applied Physics Letters», Vol. 28, No. 7, avril 1976, décrit une technique permettant de faire croître du nitrure d'aluminium de type de conductivité n sur des substrats en saphir à des températures supérieures à 1800 °C. Toutefois, ladite technique exige la présence sur les substrats en saphir d'une couche de nucléation qui doit être formée à une température nettement différente dans un appareil différent, et l'emploi d'une source frittée pré-synthétisée de nitrure d'aluminium.

Le brevet des E.U.A. No. 3 634 149 décrit un procédé permettant de faire croître du nitrure d'aluminium sur des substrats en carbure de silicium à des températures comprises entre 1800° et 2300 °C, le matériau employé pour faire croître le nitrure d'aluminium étant du nitrure d'aluminium pré-synthétisé. Toutefois, les cristaux de carbure, qu'il est difficile de faire croître de façon reproductible dans des dimensions exploitables, semblent être l'unique matériau utilisable pour réaliser des substrats reproductibles aux fins dudit procédé. Il existe par ailleurs dans la littérature technique de nombreuses descriptions de procédés permettant de faire croître du nitrure d'aluminium sur du saphir et d'autres types de substrat à des températures de l'ordre de 1500 °C par transport effectué en phase vapeur, en utilisant des techniques faisant appel à l'emploi de plasma et de composés à base de chlore ou de fluor. Ces divers procédés sont mentionnés dans un article paru dans la publication intitulée «Journal of Crystal Growth», Vol. 34, 1976, page 263. Cependant, les caractéristiques électroniques du nitrure d'aluminium que l'on a fait croître à des températures relativement basses se sont révélées insatisfaisantes du point de vue de leur application dans des dispositifs semi-conducteurs. Ce matériau semble en effet présenter une résistance très élevée, de l'ordre de $10^{13}$ ohms/cm, et les couches obtenues semblent avoir tendance à se craqueler ou à se fissurer et même dans certains cas à se détacher du substrat.

Exposé de l'invention

La présente invention concerne un procédé et le dispositif de mise en œuvre qui permettent de synthétiser et de faire croître directement, de façon épitaxiale, du nitrure d'aluminium (AIN) sur un substrat en oxyde d'aluminium ($Al_2O_3$ ou saphir) à une température élevée et d'incorporer éventuellement des impuretés déterminant un type de conductivité donné et selon des concentrations appropriées, de façon à obtenir du nitrure d'aluminium utilisable à des fins électroniques et possédant des propriétés telles qu'il puisse être employé dans des dispositifs semi-conducteurs (notamment des émetteurs de radiations ultra-violettes). Du saphir est employé à la fois comme substrat et comme source, en prenant soin d'éviter que le saphir ne se décompose. Une seule surface de la semence de saphir est exposée aux vapeurs gazeuses contenant de l'aluminium et de l'azote dans une atmosphère chauffée, de façon à obtenir une nucléation complète et uniforme lorsqu'on augmente la température jusqu'à ce qu'elle corresponde à celle à laquelle l'opération de croissance est effectuée, pour éviter que le saphir constituant le substrat ne soit décapé ou ne se décompose, comme cela se produit dans le cas du saphir constituant la source.

La présente invention concerne donc tout d'abord un procédé de formation de nitrure d'aluminium convenant à des applications électroniques sur un substrat en oxyde d'aluminium de type saphir, caractérisé en ce qu'il comprend les étapes suivantes: – mise en place d'une source de carbone et d'une source d'un matériau contenant de l'aluminium susceptible d'être converti en nitrure d'aluminium, suffisamment près d'un substrat monocristallin en oxyde d'aluminium pour qu'on puisse obtenir un effet de convection, et – application de chaleur en présence d'azote pendant la durée de la formation d'un film de nitrure d'aluminium sur le substrat.

Elle concerne également le dispositif de mise en œuvre permettant de former du nitrure d'aluminium sur un substrat monocristallin en oxyde d'aluminium, ce dispositif étant caractérisé en ce qu'il comprend une chambre de réaction, un substrat monocristallin en oxyde d'aluminium constituant une partie de la chambre, une source de carbone, une source d'oxyde d'aluminium disposée à proximité de la source de carbone et suffisamment près du substrat pour qu'un effet de convection puisse être obtenu, des moyens permettant d'introduire un gaz de formation composé principalement par de l'azote, dans ladite chambre et de l'évacuer de cette dernière, et des moyens de chauffage permettant de porter la chambre à une température voisine de 2000 °C.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La fig. 1 représente schématiquement un dispositif dans lequel est effectuée la croissance épitaxiale du nitrure d'aluminium.

La fig. 2 représente schématiquement un autre dispositif voisin permettant de faire croître le nitrure d'aluminium et d'introduire des impuretés déterminant un type de conductivité désiré.

La fig. 3 représente schématiquement encore un autre dispositif permettant de faire croître le nitrure d'aluminium et de décaper une partie du substrat pendant la croissance.

La fig. 4 est un graphique représentant les propriétés d'absorption optique du nitrure d'aluminium.

Description de l'invention

Le procédé de la présente invention permet de faire croître épitaxialement des couches de nitrure d'aluminium, présentant le type et la conductivité requis, directement sur un substrat en saphir monocristallin en décomposant de l'oxyde d'aluminium en présence d'azote et de carbone de manière à former le nitrure d'aluminium. La réaction de croissance s'effectue, semble-t-il, de la façon suivante:

$$Al_2O_3 + N_2 + 3C \rightarrow 2AlN + 3CO \qquad (1)$$

la réaction se produisant de préférence en présence de 15% d'$H_2$.

Le rôle du $H_2$ n'est pas parfaitement compris, mais ce gaz semble permettre de débarrasser la chambre de réaction des oxydes qu'elle contient.

L'équation (1) définit la réaction de Serpek bien connue et permet, en conjonction avec l'équipement utilisé aux fins de l'opération de croissance, d'obtenir du nitrure d'aluminium de type n convenant à des applications électroniques, que l'on peut faire croître épitaxialement et de façon reproductible, sur un substrat en saphir monocristallin à des températures couramment utilisées avec les matériaux réfractaires.

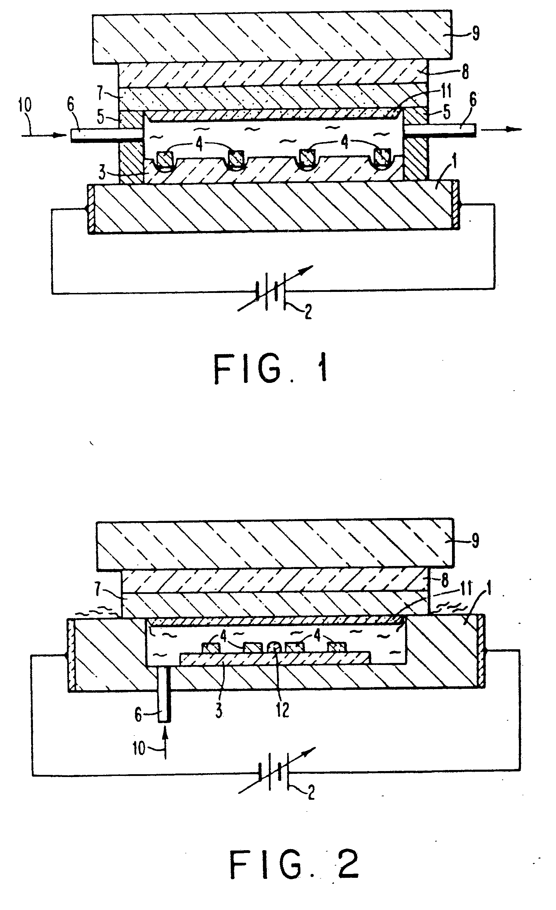

On a représenté schématiquement sur la fig. 1 un dispositif typique permettant de mettre en œuvre la présente invention et comportant un élément de chauffage 1, par exemple en tungstène, qui est excité par une source d'alimentation 2 (par exemple une batterie). Le carbone de l'équation (1) est constitué par une source de graphite pyrolytique 3 qui est en contact avec l'élément 1. La source d'oxyde d'aluminium ($Al_2O_3$ ou saphir) de l'équation (1) est constituée par les éléments 4 disposés dans des dépressions que comporte la source de graphite pyrolytique 3. Les parois 5, comportant des éléments d'admission et d'évacuation de gaz 6, soutiennent le substrat 7 en oxyde d'aluminium monocristallin et le maintiennent à une distance fixe des éléments 4. Un élément d'absorption de chaleur 8 en carbone pyrolytique ou en tungstène et un isolant 9 en feutre imprégné de carbone permettent de confiner la source de chaleur à la région de réaction et de diminuer les contraintes dans le substrat 7.

En fonctionnement normal, un gaz de formation 10, qui est de préférence constitué par l'azote, et auquel on ajoute quelques millilitres d'ammoniac par seconde, est introduit dans la région de réaction entre le substrat 7 et les éléments 4 par l'intermédiaire de l'élément d'admission 6, le trop plein s'échappant par la paroi opposée. Dans le cas d'une chambre de réaction d'une largeur de 9,4 mm environ, d'une longueur de 12,7 mm environ et d'une hauteur de 3 mm environ, un débit de 200 ml par minute peut être employé. La source d'$Al_2O_3$ peut être disposée à une distance de 5,08 à 2,03 mm environ au-dessous de l'AlN 11 que l'on fait croître.

En fonctionnement normal, le nitrure d'aluminium, de qualité utilisable dans des applications électroniques, croît épitaxialement en tant que couche 11 sur le substrat 7. Lorsque la réaction définie par l'équation (1) est en cours, le substrat est maintenu à une température comprise entre 1670° et 1870 °C et l'on porte les éléments en $Al_2O_3$, 4, à une température comprise entre 1900° et 2000 °C. La région 11 que l'on fait croître épitaxialement est du nitrure d'aluminium de type n présentant une résistivité de l'ordre de $10^5$ ohms-cm. Pour obtenir l'électroluminescence et d'autres propriétés si cela est désiré, l'effet de cette résistivité élevée peut être neutralisé en utilisant une température comprise entre 150° et 500 °C ou en procédant à la croissance supplémentaire d'une couche d'AlN de faible résistance obtenue en chauffant au contact d'une source frittée d'AlN, à une température de 1850 °C en présence d'un gaz composé de 85% de $N_2$ et de 15% de $H_2$. La couche 11 peut ensuite faire l'objet d'un traitement destiné à modifier la conductivité et le spectre de luminescence au moyen des techniques standard de diffusion et d'implantation ionique bien connues qui sont utilisées pour la fabrication des dispositifs semi-conducteurs.

On a représenté sur la fig. 2 un dispositif très voisin de celui représenté sur la fig. 1 permettant de faire croître épitaxialement une couche de nitrure d'aluminium 11 directement sur un substrat 7 en oxyde d'aluminium tout en modifiant le type et la conductivité de la couche 11 par l'introduction d'impuretés appropriées pendant cette opération.

Dans l'agencement représenté sur la fig. 2, un substrat est disposé sous la forme d'un couvercle non étanche sur une ouverture que comporte l'élément de chauffage 1. De ce fait, la source de carbone 3, sur laquelle sont disposés les éléments 4 faisant fonction de sources d'oxyde d'aluminium, peut être très rapprochée du film 11 que l'on fait croître. Le dispositif représenté comporte en outre les mêmes éléments 8 et 9 que le dispositif de la fig. 1.

Sur la fig. 2, le gaz de formation 10 de l'équation (1), qui se compose de 85% de $N_2$ et de 15% d'hydrogène, est introduit dans le dispositif par l'intermédiaire de l'élément 6. Dans cet agencement, le substrat 7, disposé de la façon qui vient d'être décrite, permet d'obtenir une croissance lente et uniforme de la couche 11, la vitesse de formation étant essentiellement limitée par l'introduction dans la chambre de réaction, du mélange gazeux et par l'évacuation du $CO_2$ et d'autres produits gazeux non utilisés, ce qui est schématiquement représenté par un écoulement gazeux au niveau de l'interface entre l'élément 1 et le substrat 7. Ce dernier et les éléments en saphir 4 sont respectivement maintenus à des températures comprises entre 1670° et 1870°C et entre 1900°C et 2000°C. A ces températures, lorsque l'espacement entre les éléments 4 et le substrat 7 est d'environ 2 mm, la vitesse à laquelle la croissance s'effectue est de l'ordre de 0,5 micron par minute. Dans de telles conditions, des impuretés déterminant un type de conductivité désiré peuvent être introduites à partir de matériaux réfractaires qui se décomposent à une température voisine de 1900°C. Ces matériaux sont introduits dans la chambre de réaction et sont représentés schématiquement par l'élément 12. Un spinelle tel que du $MgAl_2O_4$ est un matériau convenable; il contient du magnésium qui est libéré lentement et qui s'incorpore au nitrure d'aluminium que l'on fait croître. Le magnésium est un dopant de type p. A des concentrations moindres, cela fait passer la conductivité à une valeur supérieure à $10^5$ ohms-cm. Un oxyde réfractaire tel que de l'oxyde de béryllium et des nitrures réfractaires tels que ceux de néodyne, de béryllium ou de silicium conviennent également. L'addition d'impuretés peut servir à modifier les propriétés luminescentes et à déplacer la luminescence vers les régions jaune et verte du spectre.

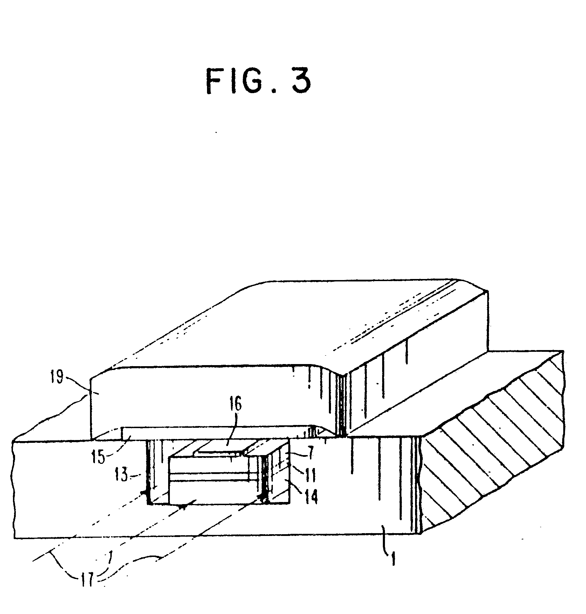

On a représenté sur la fig. 3 un autre dispositif qui permet de décaper en totalité ou en partie le substrat en oxyde d'aluminium 7 obtenu par le procédé décrit en référence aux deux figures précédentes. Il existe des applications dans lesquelles la non concordance entre les contraintes et le coefficient de dilatation relatifs, d'une part, au substrat en oxyde d'aluniniuum et, d'autre part, le nitrure d'aluminium 11 que l'on doit faire croître, est telle qu'il est souhaitable de se débarrasser de l'oxyde d'aluminium du substrat 7 après l'opération de croissance. On évite ainsi que des contraintes ne se produisent dans la couche que l'on a fait croître lors du refroidissement.

Sur la fig. 3, l'élément chauffant en tungstène 1 comporte une cavité 13 dans laquelle le substrat 7, muni de la région en nitrure d'aluminium 11 que l'on a fait croître, est disposé sur un substrat fritté 14 en nitrure d'aluminium de la façon représentée. Un élément 15 en tungstène faisant fonction de couvercle et un isolant 19 en feutre imprégné de carbone destiné à conserver la chaleur, sont séparés du substrat au moyen d'une bande de carbone 16. Dans cet agencement, le substrat 7 porté à la température de croissance de 1800°C, peut être décapé en remplaçant l'atmosphère gazeuse, introduite dans les agencements des deux figures précédentes par l'intermédiaire des éléments 6, par un nouveau gaz 17 capable d'attaquer l'oxyde d'aluminium beaucoup plus rapidement que le nitrure d'aluminium. Un tel gaz peut être, par exemple, un gaz de formation composé de 75% d'argon et de 15% d'hydrogène. Des vapeurs d'aluminium et du propane peuvent également être employés à cette fin. Etant donné que le carbone décape l'oxyde d'aluminium ou provoque sa décomposition à de telles températures, la présence de l'élément en carbone 16 permet d'accélérer le processus de décapage.

Bien que l'on ait décrit l'invention comme utilisant une source d'$Al_2O_3$, les dispositifs représentés sur les fig. 1, 2 et 3 peuvent également utiliser comme source, du nitrure d'aluminium fritté. Dans le cas de la fig. 3, l'introduction d'un gaz de formation en tant que gaz 17 comportant principalement de l'azote qui est porté à 1900° et que l'on laisse agir pendant 30 minutes permet d'obtenir une couche 11 de nitrure de silicium d'une épaisseur de 2 micron sur un substrat en saphir 7 d'une épaisseur de 5 mm. Ce gaz est alors remplacé par ce gaz de formation comportant principalement de l'argon, que l'on vient de mentionner, qu'on laisse agir pendant 1 à 2 heures, après quoi l'on constate que le substrat 7 a été décapé sur une profondeur de 0,127 mm. A titre d'exemple, la cavité 13 peut avoir une largeur de 9,40 mm environ, une hauteur de 2,03 mm environ et une longueur de 12,7 mm environ.

Pour nous résumer le procédé de la présente invention illustré sur les fig. 1 et 2 comporte donc les étapes suivantes:

Pendant la première étape du procédé, une source de carbone et une source d'oxyde d'aluminium sont disposées suffisamment près d'un substrat en oxyde d'aluminium pour qu'un effet de convection puisse être obtenu. Pendant l'étape 2, l'ensemble est chauffé en présence d'azote, lequel, conformément à l'équation (1), décompose l'oxyde d'aluminium et, grâce au carbone, on fait croître épitaxialement du nitrure d'aluminium sur l'oxyde d'aluminium. Le cas échéant, on introduit pendant l'étape 2, sans cesser de chauffer, une impureté déterminant un type de conductivité désiré dans la chambre et cette impureté est incorporée au nitrure d'aluminium pendant la croissance.

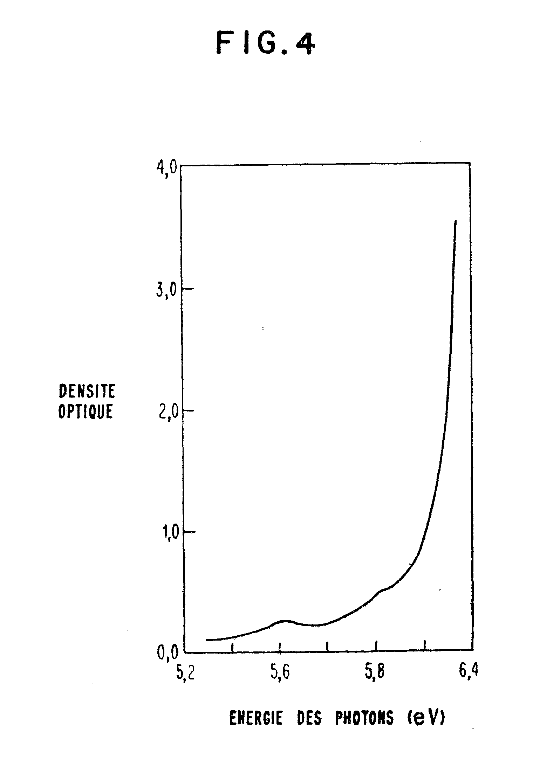

La fig. 4 est un graphique représentant les propriétés d'absorption optique d'un film cristallin de nitrure d'aluminium d'orientation cristallographique 1120 d'une épaisseur de 0,4 micron que l'on a fait croître sur un substrat en saphir ($Al_2O_3$) d'orientation cristallographique 0112. L'opération de croissance a été effectuée à 1750°C à partir d'une source frittée en AlN, 200 microgrammes environ de carbone étant présents dans la chambre de réaction de la fig. 1 de manière à favoriser une nucléation uniforme de l'AlN directement sur le saphir. Le film 11 d'AlN croît régulièrement et les impuretés indésirables qui absorbent la lumière sont réduites au minimum. Sur la fig. 4, la densité optique à l'extrémité du spectre correspondant aux courtes longueurs d'onde, c'est-à-dire de la région du graphique correspondant à une quantité élevée d'électronvolts, montre que l'AIN comporte un intervalle de bande direct et convient par conséquent à un laser lorsque celui-ci est pompé au moyen d'une source présentant une longueur d'onde correspondant à une énergie de 6,28 eV à 4°K ou à 6,2 eV à température ambiante. Une source aisément disponible est constituée par un faisceau électronique présentant une énergie de plusieurs milliers de volts.

Dans un dispositif laser, un film d'AIN formé en accord avec le procédé décrit en référence à la fig. 1 pourrait avoir une épaisseur variant entre 2 et 30 microns de manière à permettre au laser d'émettre à plusieurs longueurs d'ondes différentes dans une cavité de Fabry-Perot formée entre le substrat en saphir 7 et la surface du film 11. Ce dernier est disposé sur la face interne d'un canon à électrons et peut être recouvert d'un mince film métallique transparent aux électrons de manière à augmenter la réflectivité optique. Dans cette application, une faible résistivité est moins importante que l'absence d'impuretés indésirables. La technique de croissance de la présente invention permet d'obtenir la pureté désirée.

En conclusion le procédé de la présente invention permet de faire croître à des températures extrêmement élevées du nitrure d'aluminium utilisable dans des dispositifs électroniques et comportant les impuretés requises. Ce procédé permet d'obtenir une nucléation uniforme sur des substrats en saphir poli de manière à rendre possible la croissance de films d'un seul tenant d'une épaisseur de quelques centaines d'angströms. La présente invention permet donc de réaliser des dispositifs émetteurs de lumière dans la gamme des ultraviolets.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de formation de nitrure d'aluminium convenant à des applications électroniques sur un substrat en oxyde d'aluminium de type saphir, caractérisé en ce qu'il comprend les étapes suivantes:
mise en place d'une source de carbone et d'une source d'un matériau contenant de l'aluminium susceptible d'être converti en nitrure d'aluminium, suffisamment près d'un substrat monocristallin en oxyde d'aluminium pour qu'on puisse obtenir un effet de convection, et
application de chaleur en présence d'azote pendant la durée de la formation d'un film de nitrure d'aluminium sur le substrat.

2. Procédé selon la revendication 1, caractérisé en ce que l'étape de chauffage s'effectue en présence d'une impureté déterminant un type de conductivité désiré.

3. Procédé selon la revendication 1 ou 2, caractérisé en ce que le matériau est un oxyde d'aluminium de type $Al_2O_3$.

4. Procédé selon la revendication 1 ou 2, caractérisé en ce que le matériau est un nitrure d'aluminium fritté.

5. Procédé selon la revendication 1, 2, 3 ou 4, caractérisé en ce que l'on ajoute de l'hydrogène à l'azote dans les proportions de 15% $H_2$ pour 85% $N_2$.

6. Dispositif permettant de former du nitrure d'aluminium convenant à des applications électroniques sur un substrat monocristallin en oxyde d'aluminium, caractérisé en ce qu'il comprend:
une chambre de réaction,
un substrat mono-cristallin en oxyde d'aluminium constituant une partie de la chambre,
une source de carbone,
une source d'oxyde d'aluminium disposée à proximité de la source de carbone et suffisamment près du substrat pour qu'un effet de convection puisse être obtenu,
des moyens permettant d'introduire un gaz de formation composé principalement par de l'azote, dans ladite chambre et de l'évacuer de cette dernière, et
des moyens de chauffage permettant de porter la chambre à une température voisine de 2000 °C.

7. Dispositif selon la revendication 6 caractérisé en ce que le gaz de formation comprend également de l'hydrogène.

8. Dispositif selon la revendication 6 ou 7, caractérisé en ce que la source d'oxyde d'aluminium est remplacée par une source de nitrure d'aluminium fritté.

9. Dispositif selon la revendication 6, 7 ou 8, caractérisé en ce qu'il comprend en outre une source d'impuretés permettant de donner au nitrure d'aluminium, le type de conductivité désiré, cette source étant disposée suffisamment près du substrat pour maintenir ledit effet de convection.

**Claims**

1. Process for forming aluminium nitride useful for electronic applications on a substrate consisting of a sapphire-type aluminium oxide, characterized in that it includes the following steps:
providing a carbon source and a source of material containing aluminium able to be transformed into aluminium nitride near enough to a monocrystalline aluminium oxide substrate to obtain a convection effect, and
applying heat in the presence of nitrogen during the production of an aluminium nitride film on the substrate.

2. Process according to claim 1, characterized in that the heating step is performed in the presence of an impurity which determines the type of conductivity desired.

3. Process according to claim 1 or 2, characterized in that the material is an aluminium oxide of the $Al_2O_3$ group.

4. Process according to claim 1 or 2, characterized in that the material is a sintered aluminium nitride.

5. Process according to claim 1, 2, 3, or 4, characterized in that hydrogen is added to the nitrogen in the proportion of 15% of $H_2$ for 85% of $N_2$.

6. Apparatus for producing aluminium nitride useful for electronic applications on a monocrystalline aluminium oxide, characterized in that it includes:
a reaction chamber,
a monocrystalline aluminium oxide substrate which is part of the chamber,
a carbon source,
an aluminium oxide source in the vicinity of the carbon source, located near enough the substrate to obtain a convection effect,
means for introducing a forming gas mainly consisting of nitrogen in said chamber and for evacuating it therefrom, and
means for heating the chamber to a temperature of about 2000°C.

7. Apparatus according to claim 6, characterized in that the forming gas also contains hydrogen.

8. Apparatus according to claim 6 or 7, characterized in that the aluminium oxide source is replaced with a sintered aluminium oxide source.

9. Apparatus according to claim 6, 7, or 8, characterized in that it also includes a source of impurities to give the aluminium nitride the type of conductivity desired, this source being near enough the substrate to maintain said convection effect.

**Patentansprüche**

1. Verfahren zum Herstellen von für elektronische Anwendungen geeignetem Aluminiumnitrid auf einem Aluminiumoxidsubstrat vom Saphirtyp, gekennzeichnet durch folgende Verfahrensschritte:
Anbringen einer Kohlenstoffquelle und einer Quelle, aus einem Material, das in Aluminiumnitrid umwandelbares Aluminium enthält, und so nahe bei einem einkristallinen Substrat aus Aluminiumoxid liegt, dass ein Konvektionseffekt erzielt werden kann, und
Erhitzen in Gegenwart von Stickstoff während der Dauer der Bildung eines Aluminiumnitridfilmes auf dem Substrat.

2. Verfahren nach Anspruch 1, dadurch gekennzeichnet, dass das Erhitzen in Gegenwart einer einen gewünschten Leitungstyp erzeugenden Verunreinigung durchgeführt wird.

3. Verfahren nach Anspruch 1 oder 2, dadurch gekennzeichnet, dass das Material aus Aluminiumoxid vom Typ $Al_2O_3$ besteht.

4. Verfahren nach Anspruch 1 oder 2, dadurch gekennzeichnet, dass das Material aus gesintertem Aluminiumnitrid besteht.

5. Verfahren nach Anspruch 1, 2, 3 oder 4, dadurch gekennzeichnet, dass dem Stickstoff Wasserstoff in einem $H_2:N_2$-Mengenverhältnis von 15 zu 85 beigefügt wird.

6. Vorrichtung zum Herstellen von für elektronische Anwendungen geeignetem Aluminiumnitrid auf einem einkristallinen Substrat aus Aluminiumoxid, bestehend aus:
einer Reaktionskammer,
einem einkristallinen Aluminiumoxid, das einen Teil der Kammer darstellt,
einer Kohlenstoffquelle,
einer in der Nähe der Kohlenstoffquelle liegenden Aluminiumoxidquelle, die sich so nahe beim Substrat befindet, dass ein Konvektionseffekt erzielt werden kann,
Mitteln, um ein hauptsächlich aus Stickstoff bestehendes Schutzgas in diese Kammer einzuführen oder daraus zu entfernen,
Erhitzungsmitteln, um die Kammer auf eine Temperatur von ungefähr 2000°C zu bringen.

7. Vorrichtung nach Anspruch 6, dadurch gekennzeichnet, dass das Schutzgas auch Wasserstoff enthält.

8. Vorrichtung nach Anspruch 6 oder 7, dadurch gekennzeichnet, dass die Aluminiumoxidquelle durch eine solche aus gesintertem Aluminiumnitrid ersetzt wird.

9. Vorrichtung nach Anspruch 6, 7 oder 8, dadurch gekennzeichnet, dass sie ferner eine Verunreinigungsquelle enthält, um in dem Aluminiumnitrid den erforderlichen Leitungstyp zu erzeugen, wobei diese Quelle so nahe wie möglich beim Substrat liegen soll, um den Konvektionseffekt aufrechtzuerhalten.

FIG. 1

FIG. 2

# FIG. 3

# F I G. 4

DENSITE
OPTIQUE

ENERGIE DES PHOTONS (eV)